(19) Europäisches Patentamt
European Patent Office
Office européen des brevets

(11) Publication number: **0 015 720**
**B1**

(12) **EUROPEAN PATENT SPECIFICATION**

(45) Date of publication of patent specification: **12.10.83**

(21) Application number: **80300600.6**

(22) Date of filing: **28.02.80**

(51) Int. Cl.³: **C 08 L 79/08,** C 09 D 3/00, H 01 B 3/30, H 01 B 3/46, C 08 L 83/10, C 08 G 77/42, C 08 G 73/10, H 01 L 23/28

(54) **Copolymeric coating compositions.**

(30) Priority: **01.03.79 US 16412**

(43) Date of publication of application:
**17.09.80 Bulletin 80/19**

(45) Publication of the grant of the patent:
**12.10.83 Bulletin 83/41**

(84) Designated Contracting States:
**AT BE CH DE FR GB IT NL SE**

(56) References cited:
**FR - A - 2 335 044**
**FR - A - 2 339 252**
**US - A - 4 030 948**
**US - A - 4 051 163**
**US - A - 4 139 547**

(73) Proprietor: **M & T CHEMICALS, INC.**
**One Woodbridge Center**
**Woodbridge, New Jersey 07095 (US)**

(72) Inventor: **Berger, Abe**
**11 Malvern Drive**
**Summit New Jersey 07901 (US)**

(74) Representative: **Ellis, John Clifford Holgate et al,**
**MEWBURN ELLIS & CO. 2/3 Cursitor Street**
**London EC4A 1BQ (GB)**

**EP 0 015 720 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Copolymeric coating compositions

The present invention relates to a copolymeric coating composition comprising a curable copolymer material having a silicone component and at least one organic solvent therefor. Such coating compositions provide protective coating materials suitable, for instance, for use on semiconductor elements, metal parts such as gear teeth and cookware, and as a wire coating enamel.

Industry is always looking for improved coating materials which will protect their products as well as enhancing the physical properties thereof. Where possible, industry prefers a one component material and a simple curing cycle to achieve the desired end results. However, as the need arises, industry requires that such desirous one component materials must be capable of multiple applications to achieve a multi-layer coating wherein all layers adhere tenaciously to adjoining layers. The material must also be readily removable for component repair purposes and be adaptable for recoating in only that component repair area with the same or a similar material and still retain the integrity of the coating layer and the overall protection of the device or article of manufacture.

Some articles of manufacture have the ability to withstand high temperatures, of the order of 300°C, for short periods of time to enable the employment of a high temperature curing cycle. Other articles of manufacture cannot withstand high temperatures even for a short period of time. Therefore, the desired coating material must be available in another form whereby a single low temperature, of the order of 120°C to 150°C, curing cycle is desirable. A particular need is for curable solutions of preimidized materials wherein solvent evaporation is practical at temperatures less than 100°C and the solvent does not chemically attack epoxy resin circuit boards.

Heretofore polymer and co-polymer materials disclosed in the teachings of Hoback et al., U.S. Patent Specification No. 3,740,305, Shaw, U.S. Patent Specification No. 3,615,913, Chang et al., U.S. Patent Specification No. 3,684,592, and Berger, U.S. Patent Specifications Nos. 4,030,948 and 4,139,547, provide adequate coatings for some articles of manufacture but are unable to meet specific coating material needs for providing desired physical properties which other articles of manufacture require in order to function properly.

Therefore, it is an object of this invention to provide an improved coating composition for applying material for protecting and/or passivating selected surface areas of articles of manufacture.

Another object of this invention is to provide an improved copolymeric coating composition whose copolymer can be cured to form a coating layer film at a temperature of about 150°C or less.

According to the present invention there is provided a coating composition which comprises: a curable copolymer material (1) defined at least partially by the general formula:

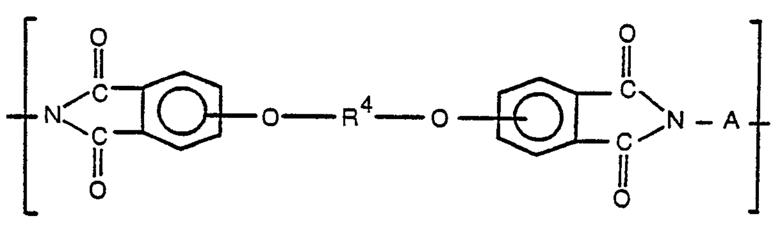
(I)

in which there are present from 40 to 99 mole percent intercondensed structural units defined by the general formula:

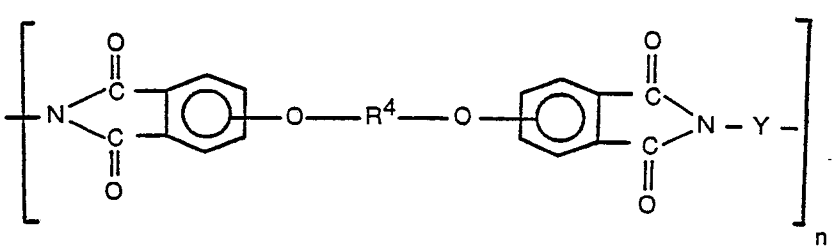
(II)

or at least partially by the general formula

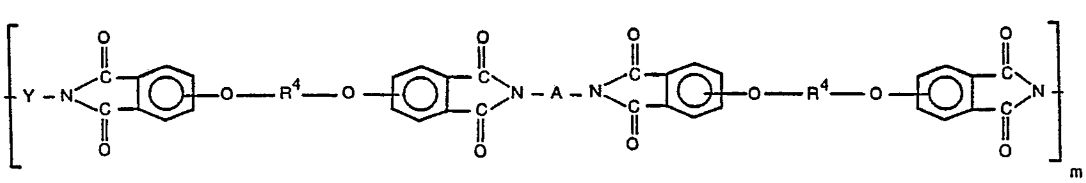
(III).

wherein in the general formulae (I) and (III) A is a silicone having the general formula:

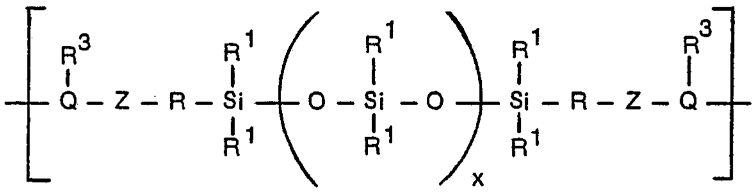

(IV),

wherein Q is an aromatic nucleus; R is a divalent group or a functional divalent group; $R^1$ is chosen from monovalent hydrocarbon radicals and functional hydrocarbon radicals, the $R^1$ radicals in the formula (IV) being the same as or different from one another; $R^3$ is hydrogen, a hydrocarbon radical or a functional group or atom; x is 0 or an integer of 1 or more;

Z is —O—, —S—, 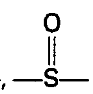 or 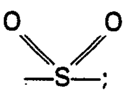;

m and n are the same or different integers and are greater than 1; Y is a divalent silicon-free organic radical which is the residue of an organic diamine or a macrocyclic crown ether, and $R^4$ is a direct linkage or a divalent organic radical, the divalent bonds of the —O—$R^4$—O— grouping being symmetrically linked to the phthalimide end groups; and at least one organic solvent (2) chosen from monoalkyl ethers of ethylene glycol, monoalkyl ethers of condensed polyethylene glycol, dialkyl ethers of ethylene glycol, dialkyl ethers of condensed polyethylene glycol, and cyclic ethers containing not less than a 5 member ring.

$R^4$ may be a divalent organic radical of the general formula

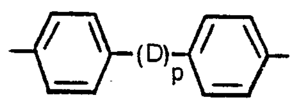

(V)

wherein D is chosen from

$—C_yH_{2y}—$, 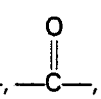, 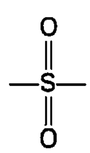 and —S—,

p being 0 or 1 and y is 0 or an integer of from 1 to 5.

Preferably the —O—$R^4$—O grouping is symmetrically linked to the phthalimide end groups in the 3,3'- or the 4,4'-positions, and preferably m and n are 10 to 10,000.

Advantageously the curable copolymer material (1) will have been derived by a condensation reaction between corresponding molar quantities of an organic diamine (x) and a silicone (y) containing a bis-amino aryl ether grouping or a bis-amino aryl thioether grouping and an organic dianhydride (z), the reaction being effected by reacting (x) + (z) and then with (y) or reacting (y) + (z) and then with (x), or the curable copolymer material has been derived by a condensation reaction between corresponding molar quantities of an organic diamine (x) which includes in its structure the required silicone grouping and an organic dianhydride (z).

With reference to the definition of y it is to be understood that the macrocyclic crown ether provides a chelant within the copolymer material (1) which is part of the chemical structure thereof.

Especially suitable organic solvents (2) are monoglyme (ethylene glycol dimethyl ether), diglyme (diethylene glycol dimethyl ether), tetrahydrofuran and 1,4 dioxane. The copolymer material (1) is in a preimidized form. The coating composition may be cured by solvent evaporation at a temperature of 150°C or less, and even as low as ~95°C when the solvent is diglyme.

The coating composition is suitable for use as wire coating enamel, junction coatings and/or passivation coatings for semiconductor and electrical devices, and coatings for metal parts such as gear teeth and cookware.

In the accompanying drawings given by way of illustration only:—

Figures 1 to 5 are elevation views, in cross-section, of electronic devices which have been coated with coating compositions embodying this invention, and

Figure 6 is a view, in cross-section, of an insulated conductor which has been coated with a coating composition embodying this invention.

U.S. 4,139,547, already referred to above, describes a silicone containing bis-thioether aromatic amine which may be represented as $H_2N—A'—NH_2$, where A' has the meaning of A given in this specification, provided that $R^3$ is not hydrogen and Z is not —O—. This patent also describes the condensation of such a silicone containing amine with an organic diamine and an organic dianhydride to form a copolymer material. The example given uses N-methyl-pyrrolidone as solvent.

The present invention essentially comprises the use, with the particular curable copolymer material (1) of specific solvents (2).

The organic solvents (2) are very stable and are inert. The solvents (2) have much less contamination than other solvents employed heretofore because the solvents have less solubility for salts which can contaminate the surface to which are applied coating compositions in which the solvent is employed. This permits the employment of a very "clean" coating composition for application requirements. An especially suitable solvent is diglyme which enables one to employ a low temperature for drawing off the solvent from a coating composition embodying the invention without contamination of the surfaces as well.

$R^4$ may have a formula chosen from the following:

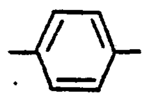 , 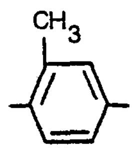 , 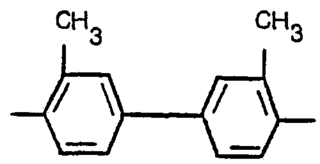 ,

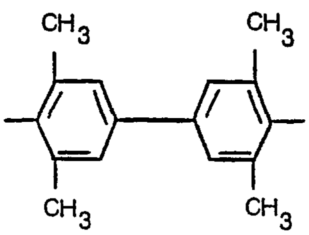 , 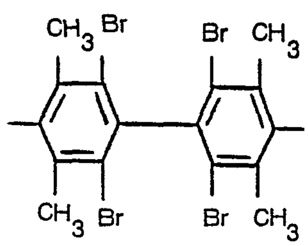 , and 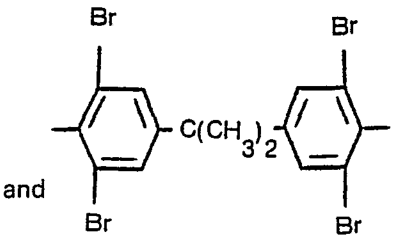 .

The above-mentioned block and random copolymers (1) can be prepared by effecting reaction, in the required molar quantities, of a mixture of ingredients comprising a silicone bis-(ether aromatic amine), the structure of which is found in Formula (IV) and a silicon-free diamino compound of the general formula:

$$NH_2—Y—NH_2 \qquad (IX)$$

with a required molar quantity of a dianhydride of the general formula:

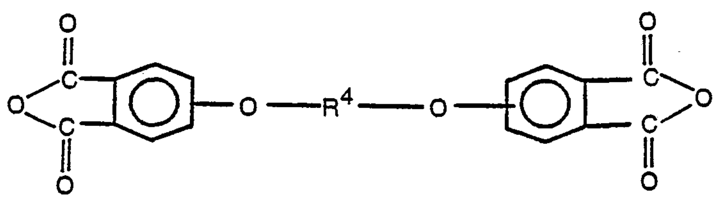

(X)

wherein $R^4$ and Y have the meanings as given hereinbefore.

Other organic tetracarboxylic dianhydrides containing no ether linkages can be added in an amount up to 50%, by molar requirements, of the total anhydride requirement of the reaction system with the diamino functional compounds. For example, the mixture of ingredients may include a second tetracarboxylic dianhydride having the formula

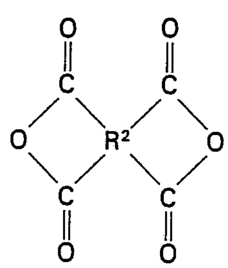

(VI)

wherein $R^2$ is a tetravalent organic radical.

Films resulting from the incorporation of the optional addition of a second ether-free dianhydride are more solvent-resistant and more stable to attack by alkali, amines or hydrazine reagents. Thus the reaction product may additionally contain up to 50 mol percent of recurring structural units of the general formula:

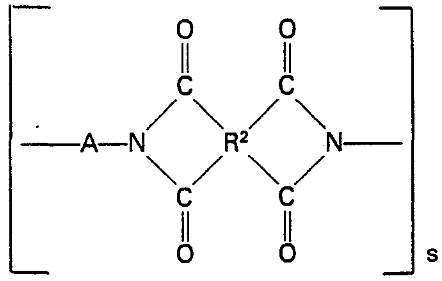

(VII)

wherein $R^2$ is as defined above, A is as defined above and S is an integer greater than 1, with from 1 to 99 mol percent of the up to 50 mol percent of the preceding recurring structural units having intercondensed structural units of the general formula:

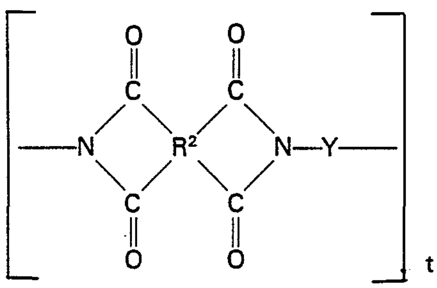

(VIII)

wherein $R^2$ and Y have the meanings as given hereinbefore and t is an integer greater than 1. Preferably s and t are the same or different integers of from 10 to 10,000.

Thus it will be recognized that the copolymer materials (1) used in this invention will consist wholly of either the block form of the structures found in Formulae (I) and (II) or the random form of the structures found in Formula (III) or, when desired, containing up to 50% of the imido structures found in Formulae (VII) and (VIII).

The silicone ether of Formula (IV) may have the same general formula described in the British Patent Specification 1,062,418 when Z is oxygen. When sulphur, the sulphoxide grouping of sulphone grouping is employed for Z in Formula (IV), the coating compositions of this invention show superior anti-oxidant properties over prior art materials. Additionally, the ether of Formula (IV) is much easier to formulate for use in making the coating compositions of the invention when Z is sulphur, the sulphoxide or sulphone grouping. When Z is the sulphone grouping, the coating compositions of this invention have very high thermal stability. Examples of suitable silicones are bis-(p-aminophenoxybutyl) tetramethyldisiloxane, bis-(m-aminophenoxybutyl) tetramethyldisiloxane, bis-(m-aminophenylthiobutyl) tetramethyldisiloxane and bis-(p-aminophenoxythiobutyl) tetramethyldisiloxane.

The diamines of Formula (IX) are described in the prior art and are to a large extent commercially available materials. Typical of such diamines from which the curable copolymer (1) may be prepared are the following:

m-phenylenediamine;
p-phenylenediamine;
4,4′-diaminodiphenylpropane;
4,4′-diaminodiphenylmethane (hereinafter referred to as "methylenedianiline");
benzidine;
4,4′-diaminodiphenyl sulphide;
4,4′-diaminodiphenyl sulphone;
4,4′-diaminodiphenyl ether;
1,5-diaminonaphthalene;
3,3′-dimethylbenzidine;
3,3′-dimethoxybenzidine;
2,4′bis(β-amino-t-butyl)toluene;
bis(p-β-amino-t-butyl)phenyl ether;
bis(p-β-methyl-o-aminopentyl)benzene;
1,3-diamino-4-isopropylbenzene;
1,2-bis(3-aminopropoxy)ethane;

m-xylylenediamine;
p-xylylenediamine;
bis(4-aminocyclohexyl)methane;
decamethylenediamine;
3-methylheptamethylenediamine;
4,4-dimethylheptamethylenediamine;
2,11-dodecanediamine;
2,2-dimethylpropylenediamine;
octamethylenediamine;
3-methoxyhexamethylenediamine;
2,5-dimethylhexamethylenediamine;
2,5-dimethylheptamethylenediamine;
3-methylheptamethylenediamine;
5-methylnonamethylenediamine;
1,4-cyclohexanediamine;
1,12-octadecanediamine;
bis(3-aminopropyl)sulphide;
N-methyl-bis(3-aminopropyl)amine;
hexamethylenediamine;
heptamethylenediamine;
nonamethylenediamine,

or a mixture of two or more thereof. It should be noted that these diamines are given merely for the purpose of illustration and are not considered to be all-inclusive. Other diamines not mentioned will readily be apparent to those skilled in the art.

The aromatic bis(ether anhydride) of Formula (X) may include the following:
2,2-bis[4-(3,4-dicarboxyphenoxy)phenyl] propane dianhydride;
2,2-bis[4-(2,3-dicarboxyphenoxy)phenyl] propane dianhydride;
4,4′-(p-phenylenedioxy)diphthalic anhydride, and
3,3′-(p-phenylenedioxy)diphthalic anhydride.

The ether-free tetracarboxylic acid dianhydrides of Formula (VI), the use of which is optional, are defined in that $R^2$ is a tetravalent organic radical, for example, a radical derived from or containing an aromatic group containing at least 6 carbon atoms characterized by benzenoid unsaturation, wherein each of the 4 carbonyl groups of the dianhydride is attached to a separate carbon atom in the tetravalent radical, the carbonyl groups being in pairs in which the groups in each pair are attached to adjacent carbon atoms of the $R^2$ radical or to carbon atoms in the $R^2$ radical at most one carbon atom removed, to provide a 5-membered or a 6-membered ring as follows:

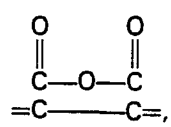,
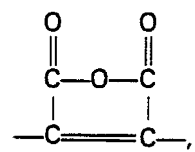, or
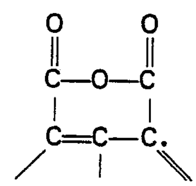

Illustrative of dianhydrides suitable for use in the present invention (with their reference designation in parenthesis) include:
pyromellitic dianhydride (PMDA);
2,3,6,7-naphthalene tetracarboxylic dianhydride;
3,3′-4,4′-diphenyl tetracarboxylic dianhydride;
1,2,5,6-naphthalene tetracarboxylic dianhydride;
2,2′,3,3′-diphenyl tetracarboxylic dianhydride;
bis(3,4-dicarboxyphenyl)sulphone dianhydride;
benzophenone tetracarboxylic acid dianhydride (BPADA);
perylene-1,2,7,8-tetracarboxylic acid dianhydride;
bis(3,4-dicarboxyphenyl)methane dianhydride, and

aliphatic anhydrides such as cyclopentane tetracarboxylic dianhydride, cyclohexane tetracarboxylic dianhydride, butane tetracarboxylic dianhydride, and the like.

In the manufacture of the copolymer materials (1) of this invention, $R^1$ of formula (IV) is preferably a monovalent hydrocarbon radical. The monovalent hydrocarbon radical material is one that is commercially available and is selected because of the economics of the manufacturing process of the end product. When $R^1$ is a functional hydrocarbon radical it is, at the present time, custom synthesized and therefore more expensive than the commercially available monovalent hydrocarbon radical. However, when the required physical properties of the copolymer end product material cannot be achieved by the use of other materials, economic factors of manufacture are overridden and functional

hydrocarbon radicals such as chloromethyl, cyanoethyl, trifluoropropyl, vinyl, chlorophenyl and the like can thereby be employed.

The coating compositions of this invention wherein the block and random polymer materials can be prepared as mixtures so that the best physical properties of each copolymer are incorporated in the final copolymer material (1). The percentages of each employed will be determined by the end product use of the resulting copolymer film produced by curing the copolymer material (1). However, each of the constituents of the mixture must have the same curing cycle. Therefore, the mixtures may consist of either (i) the high temperature cure block copolymer material and the high temperature cure random copolymer material or (ii) the low temperature cure preimidized block copolymer and the low temperature cure preimidized random copolymer material. In either mixture, each constituent can be present in any amount greater than zero with the remainder being the other constituent.

In either instance the mixture may be accomplished in two ways. In one instance the mixture can be achieved by physical means. The mixture is made by taking the appropriate amounts of each constituent and mixing them together. The mixed solution is then applied to the desired surface area and cured as described heretofore. In the second instance the mixture is achieved as a chemical mixture wherein the mixed copolymer material is chemically produced together in an initial curable form provided the constituents are compatible with each other.

In making the copolymer materials (1) used in this invention, benzophenone dianhydride may be employed to increase the solvent-resistant properties of the coating materials.

Prior art polyetherimide (PEI) coating materials are subject to attack by chlorinated solvents. The copolymer materials (1) used in this invention are more resistant to attack by chlorinated solvents by a factor of 10 or more. The copolymer materials (1) used in this invention are also more resistant (when cured) to corona by a factor of at least $10^3$ because of the presence of the aromatic silicone diamine in the chemical structure of the copolymer material (1).

The coating compositions of this invention also have an advantage in processing over the processing techniques of prior art materials. Prior art materials incorporating an aliphatic silicone diamine in the manufacture thereof cannot be refluxed for extended periods of time, such as for 15 hours at 200°C, and upwards in trichlorobenzene since gelation will occur. This gelation effect has not been noted in the coating compositions of this invention which embody an aromatic silicone diamine. Consequently, this phenomenon enables one to obtain copolymer materials having higher molecular weight polymer structures while still achieving excellent adhesion properties for tenaciously bonding the copolymer material to a substrate surface.

The solubility of the copolymer material (1) used in this invention in a solvent which is derived from monoalkyl and/or dialkyl ethers of ethylene glycol and condensed polyethylene glycols and/or cyclic ethers containing no less than a 5 member ring, such as diglyme (diethylene glycol dimethyl ether) at standard temperature and pressure is dependent upon the solids content of the coating composition in the solution and the silicone content of the copolymer material (1).

When the total solids content of the coating composition is 25 percent or greater at room temperature, the solubility of the copolymer material (1) in the solvent(s) is best when the silicone content of the copolymer material (1) is greater than 40 mol percent. The solubility of the copolymer material (1) used in the invention increases considerably when the silicone content thereof is above 40 molar percent. The inventor has been able to prepare coating compositions wherein the copolymer material (1) has included 100 mole percent silicone material.

With silicone contents of less than 40 mole percent of the copolymer material (1) used in the invention difficulty has been experienced in achieving solubility at room temperature in a reasonable time for 25 percent solids solution. However, with the application of heat, solution can be achieved.

When the total solids content is reduced to less than 25 percent solids the solubility of the copolymer materials (1) are more easily obtained at room temperature in the solvents (2).

As the solids content increases above 25 percent in the coating composition, and the silicone content of the copolymer material (1) is 40 mol percent or less, solubility of the solids is increasingly difficult to achieve at room temperature, but solubility is achieved, and more easily achieved with heating to high temperatures.

It is the inventor's belief that the silicone in the copolymer material (1) tends to solubilize the system. That is, silicone material tends to make the copolymer (1) in this particular class of solvents (2) soluble. The greater the silicone content of the copolymer material (1) becomes, the more soluble the copolymer material (1) becomes in the solvent(s) (2). This contributes to the hydrophobic characteristics of the copolymer material (1). The class of solvents (2) are much less polar in nature than the conventional dipolar aprotic solvents such as DMF, NMP,DMA, TMU, and the like, previously proposed as solvents for preparing precursor solutions of preimidized silicone-polyimide copolymer materials.

Using the specific solvents (2) coating compositions can be prepared which enable one to achieve cures by solvent evaporation at temperatures lower than with the prior art solvents. One can achieve solvent evaporation cures at less than 150°C and even less than 100°C. For example, in a coating composition containing 25 percent total solids, and in which the copolymer material (1) has a silicone content of 40 mole percent or more in diglyme, one is able to achieve solvent evaporation cures at from

~75°C to ~95°C in from 20 to 30 minutes for an applied coating of 1 millimetre to 2 millimetres in thickness.

Application of the coating compositions to substrate surfaces can be accomplished by such means as dipping, spraying, painting, spinning, and the like followed by an appropriate curing cycle. The solids content in the solution can be varied according to the mode of application, process curing facilities and desired film thickness upon curing. Repeated applications may be made to obtain a desired thickness as required as the cured copolymer material will adhere or bond to itself as tenaciously as it bonds to the substrate.

The following examples illustrate processes for making coating compositions embodying the invention, as well as a comparison to a prior art copolymer material:

Example 1

Preimidized Silicone Polyimide Copolymeric System Containing 70 Mole % 1,3-Bis-(p-aminophenoxybutyl)tetramethyldisiloxane.

To a mixture containing 10.4 parts 2,2-bis-[4(3,4-dicarboxyphenoxy)phenyl] propane dianhydride (0.02 mole), 0.648 part m-phenylene diamine (0.006 mole), and 0.1 part toluenesulphonic acid was added 231 parts o-dichlorobenzene. The reaction mixture was placed in a silicone oil bath maintained at 240°C resulting in rapid reflux.

The refluxing liquid, incorporating water which was formed in the imidization reaction, was passed over a desiccant, such as calcium hydride, and resulting dichlorobenzene was returned back to the reaction. After a period of 2—4 hours, water was no longer generated as indicated by the clear solution bathing the calcium hydride.

The silicone oil bath temperature was lowered to 200°C, followed by the addition of 6.44 g 1,3-bis-(p-aminophenoxybutyl)tetramethyldisiloxane (0.014 mole). The reaction was maintained at this temperature for four additional hours. Thereafter, the heating bath was removed. The polymeric solution was cooled, filtered and precipitated into a large volume of methanol. The resulting white fibrous copolymer material was collected by filtration, washed five times with additional fresh methanol, and dried at 5 mm pressure and 65°C overnight. There was obtained 15.2 g copolymer material. To this copolymer material was added 45.6 parts freshly distilled diglyme and the resulting mixture was stirred until complete solution was obtained.

The resulting solution consisted of a preimidized silicone-polyimide copolymer material having 70 mole percent 1,3-bis-(p-aminophenoxybutyl) tetramethyldisiloxane in diglyme.

A portion of the preimidized copolymer material in solution was disposed on several glass slides and cured at 85°C for 2 hours to effect a complete cure. The resulting film bonded very tenaciously to the glass slide. Additionally, the film exhibited excellent resistance to abrasion and impact. When subjected to immersion in boiling water for 6 hours, the film remained very tenaciously bonded to the surface of the glass slide.

Several more glass slides were prepared and coated with another portion of the preimidized copolymer material solution and cured in the same manner as before. The coated slides were weighed to determine the weight of the copolymer material applied.

The preweighed slides were placed in an air circulating oven and heated to 300°C ± 10°C for a period of 8 hours and then removed from the oven and cooled to ambient temperature.

Upon reweighing the slides, no loss in weight could be detected.

It is believed that the aryl ether portion of the copolymer material inhibits free radical degradation. In other words, it is a free radical scavenger inhibiting destruction by a radical propagation reaction. Therefore, no appreciable weight loss could be detected on weighing the coated slide after the exposure to 300°C for 8 hours.

Unexpectedly, the silicone containing copolymer material used in this invention retains its stability in circulating air at high temperature even with increased aryl ether silicone content.

Example II

Preimidized Silicone-Polyimide Copolymer Material Containing 100% Silicone Diamine.

To a reaction mixture consisting of 4.32 parts bis-(p-aminophenoxypropyl)tetramethyldisiloxane and 0.1 part toluenesulphonic acid in 90 grams of dichlorobenzene was added all at once, 5.20 parts, 2,2-bis[3,4-dicarboxyphenoxy)phenyl]propane dianhydride. The reaction mixture was heated to reflux such that the water formed by the reaction was removed azeotropically with the solvent and passed over a solid desiccant which removed the water chemically and returning the solvent back to the reaction site. When water was no longer evolved, the bath temperature was lowered to 175°C and the reaction was allowed to continue overnight. The copolymeric solution was then cooled and filtered. The filtered copolymeric solution was then added to a ten fold excess of methanol to precipitate the copolymer material. The copolymer material was white and fibrous. The precipitated copolymer material was separated by filtration, washed several times with fresh methanol, and dried overnight in an oven maintained at a temperature of 65°C.

A chemical analysis of the copolymer material confirmed the proposed structure.

A portion of the copolymer material was placed in a beaker and sufficient amount of diglyme was

added to the copolymer material to prepare a solution having a 25% total solids content. A portion of the solution was applied to the surface of a ceramic plate and cured in a preheated oven maintained at 75°C for a period of 60 minutes. Upon examination of the coated ceramic plate after it was removed from the oven, it was discovered that a strong transparent film of about 8 mils in thickness had been formed on the ceramic plate. The film was bonded tenaciously to the ceramic substrate. The cured film was resistant to abrasion and could not be peeled off, or stripped from, the substrate in a continuous form.

The coated plate, with the cured film was immersed in the solvent, methylene chloride, for a period of 30 minutes. Upon removal from the solvent, the film had been removed from the ceramic. That is, the surface of the ceramic plate was completely free of the cured film of copolymer material.

As stated previously the coating compositions of this invention are particularly suitable for use as wire enamels, and conformal, protective and/or junction coatings were appropriate for electrical devices, printed circuit boards, semiconductor devices and the like.

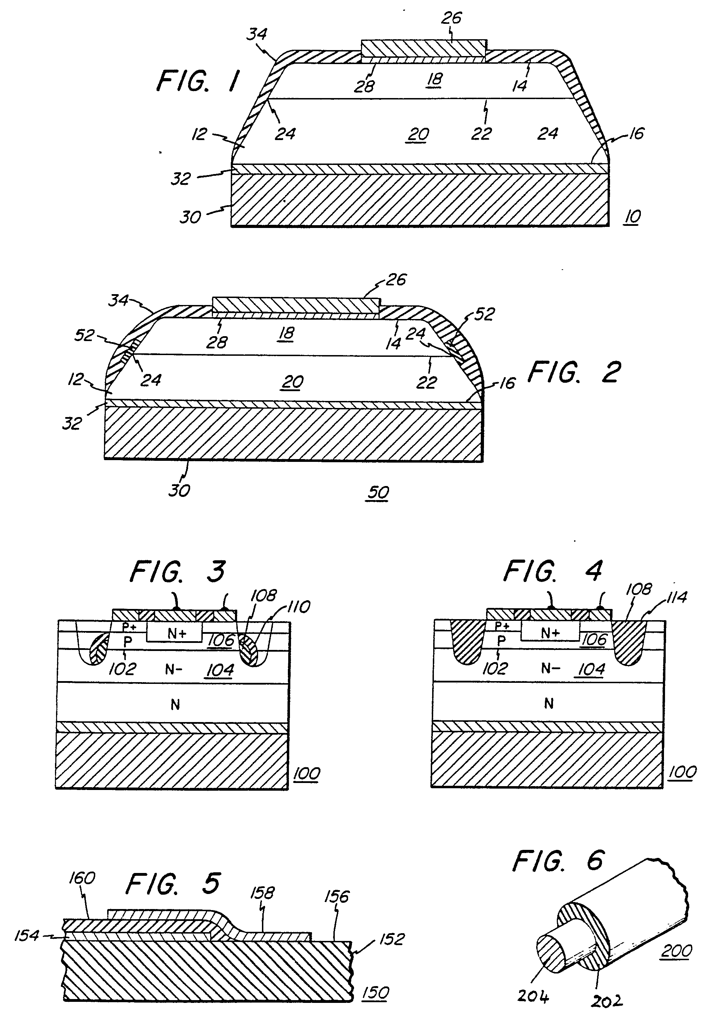

Referring now to Figure 1 of the accompanying drawings, there is shown a semiconductor element 10 coated by a coating composition embodying this invention. The element 10 is comprised of a body 12 of single crystal semiconductor material. A suitable semiconductor material for comprising the body 12 may be silicon, silicon carbide, germanium, gallium arsenide, a compound of a Group III element and a Group V element of the Periodic Table or a compound of a Group II element and a Group VI element of the Periodic Table. In order to describe the invention more fully, and for purposes of illustration only, the body 12 is said to be comprised of silicon semiconductor material.

The body 12 is prepared by suitable means, such, for example, as by polishing and lapping to parallelism two major opposed surfaces 14 and 16. The body 12 has two, or more, regions 18 and 20 of alternate and opposite type conductivity. A P—N junction 22 is formed by the contiguous surfaces or each abutting pair of regions of opposite type conductivity. End portions 24 of the P—N junction 22 are exposed to the surface area of the body 12.

A first electrical contact 26 is affixed to, and is in an electrically conductive relationship with, the region 18 by a layer 28 of a suitable electrically conductive solder material. A second electrically conductive contact 30 is affixed to the bottom surface 16 of the body 12 by a layer 32 of a suitable electrically conductive solder material. The electrical contacts 26 and 30 provide means for electrically connecting the element 10 into electrical circuitry. When required, the contacts 26 and 30 should exhibit good thermal conductivity to properties as well in order to dissipate any heat generated in the body 12 particularly in high voltage, high ampere power devices.

One or more layers 34, as required, of a copolymer coating applied from a coating composition embodying this invention is disposed on at least selected surface areas of the body 12 wherein the end portions 24 of P—N junctions 22 are exposed thereat. Preferably, it is desirable to apply the material layer 34 to all exposed surface areas of the body 12.

The copolymer protective coating material applied from a coating composition embodying the invention is suitable for use with electric devices since they have several desirable physical characteristics. The coating material is one which can easily be applied and cured in place. The material will not degrade, and enhances, the electrical characteristics of the device to which it is applied. The material adheres very tenaciously to the surface to which it is applied to prevent migration of ions on the surface of the device, particularly when employed with semiconductor devices, and does not release any materials during a curing cycle which are deleterious to the operating characteristics of the device. The coating is impermeable to moisture and exhibits good abrasion resistance when cured to protect the surfaces to which the coating is applied.

The said protective coating material is also capable of being applied in multiple layers to provide a thick coating when required. The copolymer material (1) is able to bond well to itself. Should the electronic device be employed in circuitry where corona is a problem, the material exhibits good corona resistance when cured.

When a copolymer material (1) is not capable of inherently exhibiting all of the above desired characteristics to the degree necessary, it is capable of being modified to achieve the desired end result. Often times stray alkali and heavy metal ions cause undesirable degradation of electrical properties of semiconductor devices. Therefore, the copolymer material (1) can be one which has been modified with one or more chelating materials admixed therewith or chemically bonded thereto. Ease of application to the surface to be protected and reasonably short curing times are still retained. This is of particular interest when the coating material is employed in commercial manufacturing of mass-produced electronic devices.

The coating material when cured is highly translucent. Such a material, when retaining the other desirable characteristics, is invaluable to photovoltaic devices. Particularly, it is desirable to bond a light emitting diode to the surface of another semiconductor device to turn the device "on" and "off" in response to the operation of the light emitting diode. The copolymer material (1) used in this invention is also applicable for use in bonding protective covers to exposed surfaces of photovoltaic devices (solar cells).

The applied copolymer material (1) to the body 12 by applying a coating composition embodying this invention is cured in situ by employing an appropriate curing cycle as described heretofore. When

cured in situ, the copolymer coating material (1) has a chemical structure as described heretofore. The layer 34 of cured coating material adheres tenaciously to the silicon surface upon which it is disposed. The cured coating material is impervious to moisture and gases such, for example, as oxygen and nitrogen. The cured material has excellent abrasion resistance properties to protect the element, corona resistance and dielectric strength. The excellent adherence to the surface apparently is responsible for a significant reduction in current leakage on the surface of the body 12 and particularly in the vicinity of the end portions 24 of the P—N junction 22 exposed in the surface of the body 12.

The dielectric strength of the cured material of the layer 34 may be further enhanced by including suitable filler materials in the coating compositions applied. Preferably, an electrically insulating material having a dielectric constant which is approximately the same as the material of the layer 34 is included in the coating composition applied. The filler material is uniformly distributed throughout the coating material as applied. Other materials suitable as a filler material are those materials known to have a relatively good ability to resist electrical conduction although their dielectric constant is higher than that of the material of the layer 34. Suitable electrically insulating filler materials have been found to include aluminium oxide, silicon oxide, glass fibres, boron nitride, quartz, mica, magnesium oxide, activated polytetrafluorethylene, and the like, in a finely divided, or pulverized form.

With either a filled, or an unfilled coating composition of this invention is employed to provide the required coating, the electrical properties of the element 10 are enhanced. The cured coating material of the layer 34 has an inherent elasticity to withstand repeated cycling from dipping in liquefied gases at temperature ranges of approximately −100°C to heating in a furnace at approximately 300°C and back into a liquefied gas for a temperature excursion range of about 400°C or more. Additionally, we have found the cured materials of the layers 34 to withstand short temperature excursions up to about 400°C to 500°C without degradation of the electrical characteristics of the element 10.

The material of the layer 34 may also be applied over electrically insulating layers of silicon oxide, silicon nitride, aluminium nitride and the like. Referring now to Figure 2 of the accompanying drawings, there is shown an element 50 which is an alternative embodiment of the element 10. All items donated by the same reference numerals are the same, and function in the same manner, as the corresponding item in Figure 1.

The element 10 is modified by the deposition of a layer 52 of an electrically insulating material on at least the exposed end portions of the P—N junction 22 and the adjacent surface areas of the body 12. The layer 52 minimizes the current leakage across the exposed end portions. The material of the layer 52 is one selected from silicon oxide, silicon nitride and aluminium nitride. One or more layers 34 of a filled or an unfilled coating composition embodying this invention is applied to provide a coating over at least the layer 52 to protect the integrity of the electrical properties of the element 50.

The coating compositions of this invention are also suitable, because of their ease of application and curing, for providing a protective coating for semiconductor elements embodying a "moat" type isolation groove. Moats or grooves are suitable for use in high power semiconductor elements wherein current leakage which occurs at exposed end portions of P—N junctions must be controlled.

As shown with reference to Figure 3 of the accompanying drawings, a high-speed power transistor 100, the end portions of P—N junction 102 formed by the abutting surfaces of the N-region 104 and the P-region 106 must be protected by a suitable dielectric protective coating.

The protective coating may comprise one or two layers 108 and 110 of suitable material which are the same as, or different from, each other. The material of the layer 108 and 110 may be any of the materials described heretofore relative to the layer 34 of the elements 10 and 50 of Figures 1 and 2, respectively. Additionally, the layer 108 may also comprise one of the electrically insulating materials comprising the layer 52 of the element 50.

Referring now to Figure 4 of the accompanying drawings, the layer 108 of dielectric protective coating material is shown deposited in a moat or groove 114 employed to control leakage across the end portions of the P—N junction 102 exposed therein. Often it is easier to fill the groove by "painting" or by silk-screening and curing in situ.

With reference to Figure 5 of the accompanying drawings, there is shown a portion of a printed circuit board assembly 150. The assembly comprises a board 152 of suitable material such as, for example, fibreglass, phenolic resin or melamine resin impregnated cloth and the like. A first electrically conductive metal circuit 154 is disposed on a selected portion of the surface 158 of the board 152. A second electrically conductive metal circuit 158 is disposed on another portion of the surface 156 and overlies, in part, a portion of the circuit 154. The material of the circuits 154 and 158 may be of copper, aluminium and the like. A layer 160 of a suitable coating material such, for example, as described with reference to the layer 34 of the elements 10 and 50, described heretofore, is disposed on at least the circuit 154. When cured in situ, the material of the layer 160 shows excellent adherence to the board 152 and the material of the circuit 154. The metal of the layer 158 adheres well to the cured coating material and is electrically isolated thereby from the metal circuit 154.

Referring now to Figure 6 of the accompanying drawings, there is shown a portion 200 of an insulated electrical conductor embodying a layer 202 of a coating material disposed on an electrically conductive wire 204. The coating material has been obtained by applying a coating composition

embodying this invention and curing same. The total thickness of the material of the layer 202 may be achieved by one or more applications of said coating composition followed by practising an appropriate curing cycle. By employing a preimidized material (copolymer material (1)) used in this invention, the coating layer 202 may be applied by a suitable continuous wire coating means similar to present day techniques practised for coating wire with a wire enamel. The insulated electrical conductor is suitable for use in manufacturing windings for electrical motors and generators.

The reader will note that two processes may be employed to make the copolymer material (1) used in the coating composition of this invention. These processes are possible because of the use of the aromatic silicone ether amines described heretofore. The heretofore disclosed aromatic silicone ether amines are thermally stable and able to withstand long periods of heating at elevated temperatures without gelatinizing. These aromatic silicone ether amines therefore enable one to run reactions at higher concentrations than prior art processes thereby making for more efficient use of the available capacity of kettles in manufacturing plant. Concentrations of from 8 percent to 15 percent are possible, thereby increasing kettle capacity a minimum of $33\frac{1}{2}$ percent and possibly 100 percent over prior art processes.

In processing three components to make the copolymer material (1), the following procedure may be followed:

(a) the anhydride material is first reacted with the major component of the two remaining component materials by stirring in a suitable solvent. This major component may be either an organic amine or an aromatic silicone ether amine;

(b) the reaction between the anhydride material and the major component material is a refluxing mixture and water is produced;

(c) the water produced by the refluxing mixture is removed by effecting azeotropic water removal;

(d) upon completion of removing all the water produced by the refluxing reaction, the mixture is cooled, generally to room temperature or slightly above;

(e) the third component material, either an organic amine or an aromatic silicone ether amine, is then added to the mixture and the mixture heated to an elevated temperature for a sufficient time to produce a polymeric solution of the polyimide-silicone copolymer material;

(f) upon completion of the last reaction, the resulting product of a polyimide-silicone copolymer material is recovered by a suitable process such, for example, as precipitation of the copolymeric solution in an excess amount of methanol;

(g) the precipitated copolymer is separated by filtration, washed several times in fresh methanol and dried, preferably at an elevated temperature of about 60°C to 70°C, under vacuum, to effect volatization of the methanol and any adhering solvent.

The polymer solution is preferably filtered before precipitation in the methanol.

In processing two components to make the copolymer material (1), the following process may be practised:

(a) a reaction mixture of an anhydride material and an aromatic silicone ether amine is prepared and stirred in a suitable solvent;

(b) the reaction between the two component materials produces water in a refluxing reaction;

(c) the water produced by the refluxing reaction is removed by effecting azeotropic water removal;

(d) upon complete removal of the water, the resulting copolymeric solution is cooled and recovered by a suitable process such, for example, as by pouring the polymeric solution into an excess amount of methanol to precipitate the produce;

(e) the precipitated copolymer material is separated by filtration, washed several times in fresh methanol and dried, preferably at an elevated temperature of about 60°C to 70°C, under vacuum to effect volatilization of the methanol and any adhering solvent.

Preferably, the polymeric solution is filtered before precipitation in the methanol.

Neither one of the two processes requires the use of a chemical dehydrating agent for effecting cyclo-dehydration for converting the polyamic acid form. The processes are carried out under strictly neutral conditions. Essentially the processes substantially eliminate any corrosion problems which are inherent in prior art chemical cyclo-dehydration processes. Solvents employed in the processes can be recovered and reused with no loss in chemical reactivity. Additionally, no waste byproducts are generated which could create disposal problems and detrimentally affect environmental standards specified presently by local, state and federal governments in the United States of America.

## Claims

1. A coating composition characterised in that it comprises:

a curable copolymer material (1) defined at least partially by the general formula:

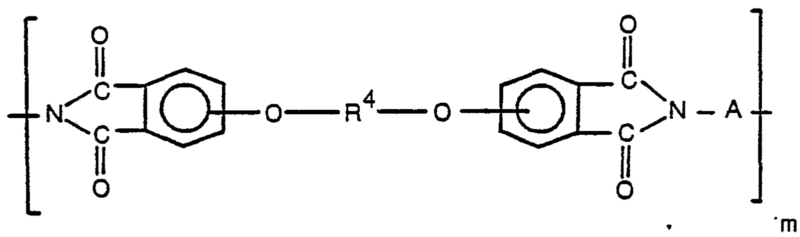 (I)

in which there are present from 40 to 99 mol percent intercondensed structural units defined by the general formula:

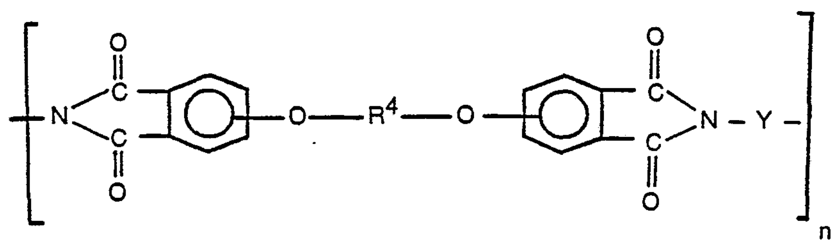 (II)

or at least partially by the general formula:

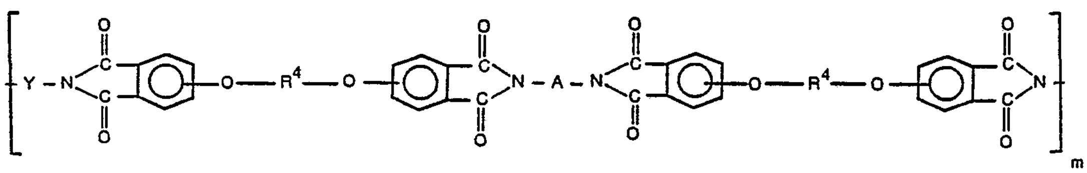 (III),

wherein in the general formulae (I) and (III) A is a silicone having the general formula:

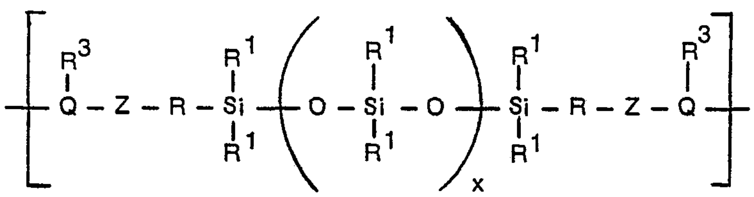 (IV),

wherein Q is an aromatic nucleus;

R is a divalent group or a functional divalent group;

$R^1$ is chosen from monovalent hydrocarbon radicals and functional hydrocarbon radicals, the $R^1$ radicals in the formula (IV) being the same as or different from one another;

$R^3$ is hydrogen, a hydrocarbon radical or a functional group or atom;

x is 0 or an integer of 1 or more;

Z is —O—, —S—, 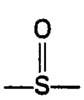 or 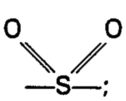;

m and n are the same or different integers and are greater than 1;

Y is a divalent silicon-free organic radical which is the residue of an organic diamine or a macrocyclic crown ether, and $R^4$ is a direct linkage or a divalent organic radical, the divalent bonds of the —O—$R^4$—O— grouping being symmetrically linked to the phthalimide end groups; and

at least one organic solvent (2) chosen from monoalkyl ethers of ethylene glycol, monoalkyl ethers of condensed polyethylene glycol, dialkyl ethers of ethylene glycol, dialkyl ethers of condensed polyethylene glycol, and cyclic ethers containing not less than a 5 member ring.

2. A coating composition according to Claim 1, wherein $R^4$ is a divalent organic radical of the general formula

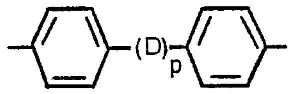

(V)

wherein D is chosen from

$-C_{y'}H_{2y}-$, 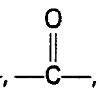, 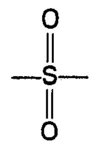 and —S—,

p being 0 or 1 and y is 0 or an integer of from 1 to 5.

3. A coating composition according to Claim 1 or Claim 2, wherein the —O—$R^4$—O grouping is symmetrically linked to the phthalimide end groups in the 3,3′- or the 4,4′-positions.

4. A coating composition according to any preceding claim, wherein m and n are 10 to 10,000.

5. A coating composition according to any preceding claim, wherein the curable copolymer material (1) has been derived by a condensation reaction between corresponding molar quantities of an organic diamine (x) and a silicone (y) containing a bis-amino aryl ether grouping or a bis-amino aryl thioether grouping and an organic dianhydride (z), the reaction being effected by reacting (x) + (z) and then with (y) or reacting (y) + (z) and then with (x), or the curable copolymer material has been derived by a condensation reaction between corresponding molar quantities of an organic diamine ($x^1$) which includes in its structure the required silicone grouping and an organic dianhydride (z).

6. A coating composition according to any preceding claims, wherein $R^4$ has a formula chosen from the following:

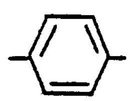, 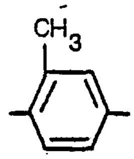, 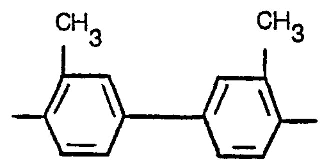,

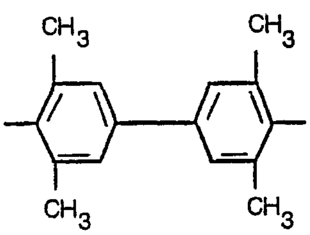, 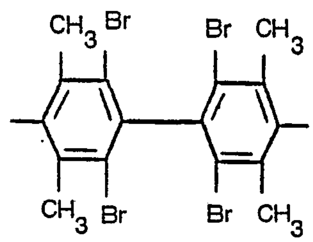, 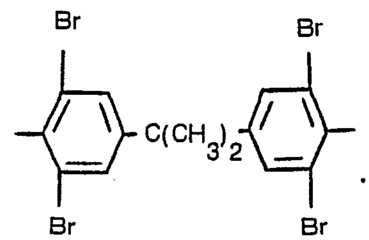.

7. A coating composition according to Claim 6, wherein the organic diamine (x) is 4,4′-diaminodiphenylmethane, m-phenylene diamine or p-phenylene diamine.

8. A coating composition according to Claim 6 or Claim 7, wherein the silicone (y) is bis-(p-aminophenoxybutyl)tetramethyldisiloxane, bis-(m-aminophenoxybutyl)tetramethyldisiloxane, bis-(m-aminophenoxypropyl)tetramethyldisiloxane, bis-(m-aminophenylthiobutyl)tetramethyldisiloxane or bis-(p-aminophenoxythiobutyl)tetramethyldisiloxane.

9. A coating composition according to Claim 5 or any claim appendant thereto, wherein up to 50 mol percent of the total organic dianhydride required for the reaction system with the diamino functional compounds consists of at least one organic tetracarboxylic dianhydride containing no ether linkage and having the general formula:

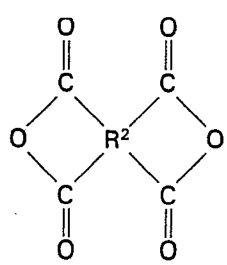

(VI)

wherein $R^2$ is a tetravalent organic radical, the product of the condensation reaction contains up to 50 mol percent of recurring structural units of the general formula

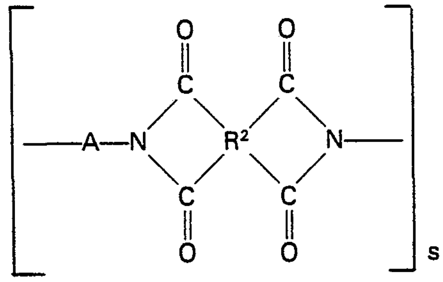

(VII)

wherein $R^2$ is as defined above, A is as defined in Claim 1 and s is an integer greater than 1, with from 1 to 99 mol percent of the up to 50 mol percent of the preceding recurring structural units having intercondensed structural units of the general formula

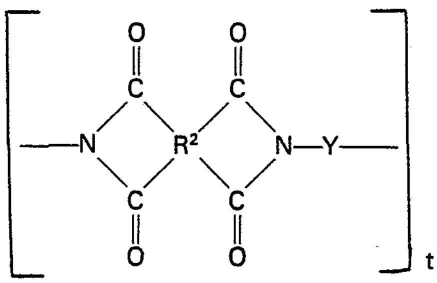

(VIII)

wherein $R^2$ is as defined above, Y is as defined in Claim 1 and t is an integer greater than 1.

10. A coating composition according to Claim 9, wherein s and t are the same or different integers of from 10 to 10,000.

11. A coating composition according to any preceding claim, wherein the total solids content of the curable copolymer material (1) in the coating composition is at least 25 percent.

12. A coating composition according to any preceding claim, wherein the organic solvent(s) (2) comprise(s) diethylene glycol dimethylether.

**Patentansprüche**

1. Beschichtungszusammensetzung, dadurch gekennzeichnet, daß sie ein aushärtbares copolymeres Material (1) enthält, die wenigstens teilweise durch die allgemeine Formel

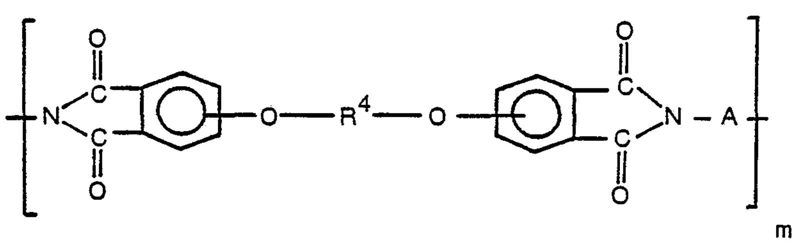

(I)

definiert werden kann, worin 40—99 Mol-% an interkondensierten Struktureinheiten vorliegen, die durch die allgemeine Formel

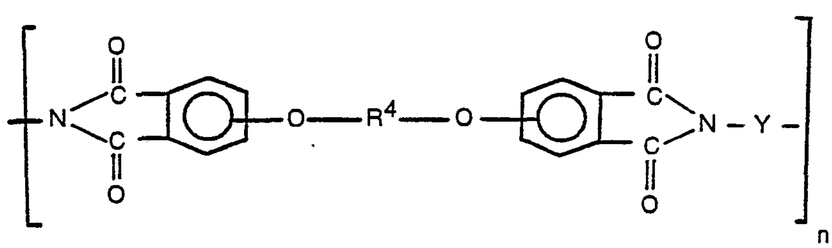

(II)

oder wenigstens teilweise durch die allgemeine Formel

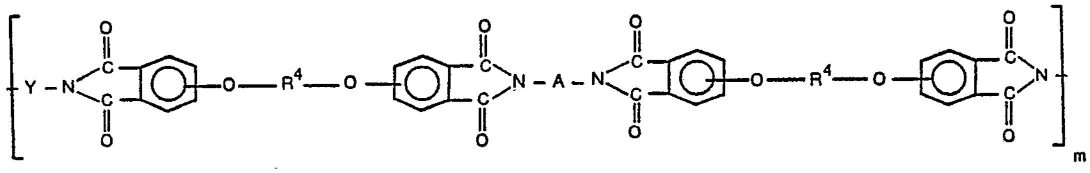 (III),

definiert werden können, worin in den allgemeinen Formeln (I) und (III) A für ein Silikon der allgemeinen Formel

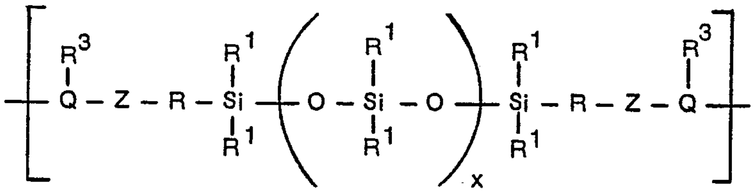 (IV),

steht, worin Q ein aromatischer Kern ist; R eine zweiwertige Gruppe oder eine funktionelle zweiwertige Gruppe ist; $R^1$ ein einwertiger Kohlenwasserstoffrest oder ein funktioneller Kohlenwasserstoffrest ist und die Reste $R^1$ in der Formel (IV) gleich oder voneinander verschieden sein können; $R^3$ für Wasserstoff, einen Kohlenwasserstoffrest, eine funktionelle Gruppe oder ein Atom steht; x gleich 0 oder eine ganze Zahl von 1 oder mehr ist;

Z —O—, —S—, 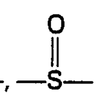 oder 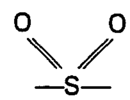

ist; m und n gleiche oder verschiedene ganze Zahlen von mehr als 1 bedeuten; Y für einen zweiwertigen, silikonfreien organischen Rest steht, welcher den Rest eines organischen Diamins oder eines makrocyclischen Kronenäthers darstellt und $R^4$ eine direkte Bindung oder einen zweiwertigen organischen Rest darstellt, wobei die zweiwertigen Bindungen der —O—$R^4$—O—Gruppierung symmetrisch an die endständigen Phthalimidgruppen gebunden sind und wenigstens ein organisches Lösungsmittel (2) enthalten ist, das aus der Gruppe der Monoalkyläther von Äthylenglycol, Monoalkyläther von kondensiertem Polyäthylenglycol, Dialkyläther von Äthylenglycol, Dialkyläther von kondensiertem Polyäthylenglycol und cyclischen Äther gewählt ist, die einen Ring mit wenigstens 5 Gliedern umfassen.

2. Beschichtungszusammensetzung nach Anspruch 1, dadurch gekennzeichnet, daß $R^4$ ein zweiwertiger organischer Rest der allgemeinen Formel

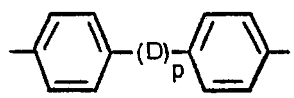 (V)

ist, worin D aus

—$C_{y'}H_{2y}$—, 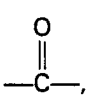, 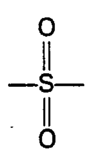 und —S—,

gewählt wird, worin P für 0 oder 1 steht und y 0 oder eine ganze Zahl von 1—5 darstellt.

3. Beschichtungszusammensetzung nach Anspruch 1 oder 2, dadurch gekennzeichnet, daß die —O—$R^4$—O—Gruppierung symmetrisch an die endständigen Phthalimidgruppen in 3,3′-Stellung oder 4,4′-Stellung gebunden ist.

4. Beschichtungszusammensetzung nach einem der vorhergehenden Ansprüche, dadurch gekennzeichnet, daß m und n 10—10.000 bedeuten.

5. Beschichtungszusammensetzung nach einem der vorhergehenden Ansprüche, dadurch gekennzeichnet, daß das aushärtbare copolymere Material (1) durch eine Kondensationsreaktion zwischen entsprechenden Molmengen eines organischen Diamins (x) und eines Silikons (y), das eine bis-Aminoaryläthergruppe oder eine bis-Aminoarylthioäthergruppe enthält, mit einem organischen Dianhydrid (z) hergestellt wird, wobei die Reaktion durch Umsetzen von (x) + (z) und dann (y) oder (y) + (z) und dann mit (x) durchgeführt wird, oder daß das aushärtbare copolymere Material durch eine Kondensationsreaktion von entsprechenden Molmengen eines organischen Diamins ($x^1$), dessen Struktur die erforderliche Silikongruppierung aufweist, mit einem organischen Dianhydrid (z) erhalten wird.

6. Beschichtungszusammensetzung nach einem der vorhergehenden Ansprüche, dadurch gekennzeichnet, daß $R^4$ eine der folgenden Formeln aufweist:

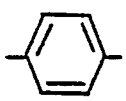 , 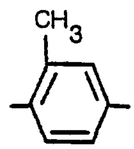 , 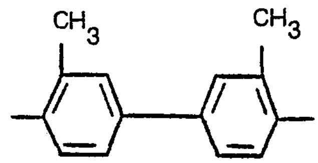 ,

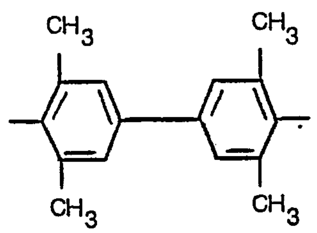 , 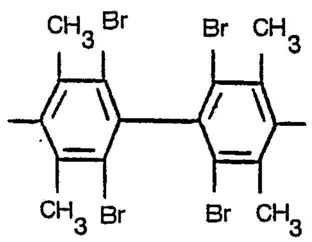 , 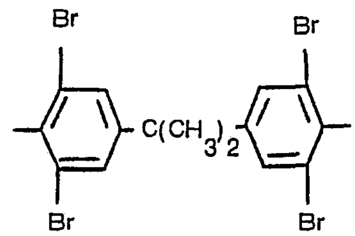 .

7. Beschichtungszusammensetzung nach Anspruch 6, dadurch gekennzeichnet, daß das organische Diamin (x) 4,4'-Diaminodiphenylmethan, m-Phenylendiamin oder p-Phenylendiamin ist.

8. Beschichtungszusammensetzung nach Anspruch 6 oder 7, dadurch gekennzeichnet, daß als Silikon (y) Bis-(p-Aminophenoxybutyl)tetramethyldisiloxan, Bis-(m-Aminophenoxybutyl)tetramethyldisiloxan, Bis-(m-Aminophenoxypropyl)tetramethyldisiloxan, Bis-(m-Aminophenylthiobutyl)tetramethyldisiloxan oder Bis-(p-Aminophenoxythiobutyl)tetramethyldisiloxan eingesetzt wird.

9. Beschichtungszusammensetzung nach Anspruch 5 oder einem der auf diesen Anspruch rückbezogenen Ansprüche, dadurch gekennzeichnet, daß bis zu 50 Mol-% des gesamten, für das Reaktionssystem mit den funktionellen Diaminoverbindungen erforderlichen organischen Dianhydrids aus wenigstens einem organischen Tetracarbonsäuredianhydrid bestehen, das keine Ätherbindung aufweist und die allgemeine Formel

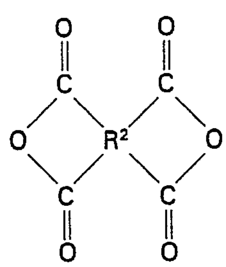 (VI)

besitzt, worin $R^2$ ein vierwertiger organischer Rest ist, und das Produkt der Kondensationsreaktion bis zu 50 Mol-% periodisch wiederkehrender Struktureinheiten der allgemeinen Formel

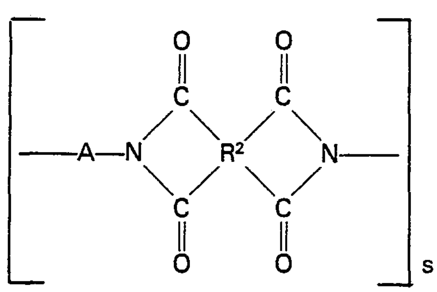 (VII)

aufweist, worin $R^2$ die oben angeführte Bedeutung besitzt, A die in Anspruch 1 angeführte Bedeutung aufweist und s eine ganze Zahl von mehr als 1 ist, mit 1—99 Mol-% der bis zu 50 Mol-% der vorstehend angeführten, periodisch wiederkehrenden Struktureinheiten umgesetzt wird, die interkondensierte Struktureinheiten der allgemeinen Formel

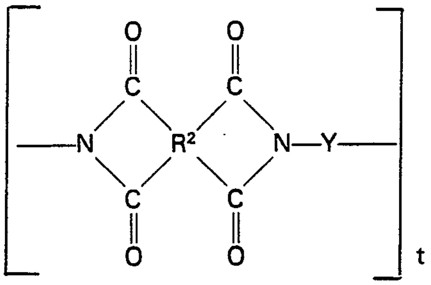 (VIII)

aufweisen, worin $R^2$ die oben angeführte Bedeutung besitzt, Y wie in Anspruch 1 definiert ist und t für eine ganze Zahl von mehr als 1 steht.

10. Beschichtungszusammensetzung nach Anspruch 9, dadurch gekennzeichnet, daß s und t gleiche oder voneinander verschiedene ganze Zahlen von 10—10.000 sind.

11. Beschichtungszusammensetzung nach einem der vorhergehenden Ansprüche, dadurch gekennzeichnet, daß der gasamte Feststoffgehalt des aushärtbaren copolymeren Materials (1) in der Beschichtungszusammensetzung wenigstens 25% beträgt.

12. Beschichtungszusammensetzung nach einem der vorhergehenden Ansprüche, dadurch gekennzeichnet, daß das (die) organische(n) Lösungsmittel (2) Diäthylenglycoldimethyläther umfaßt (umfassen).

**Revendications**

1. Composition de revêtement, caractérisée en ce qu'elle comprend:

un matériau de copolymère durcissable (1) défini au moins partiellement par la formule générale:

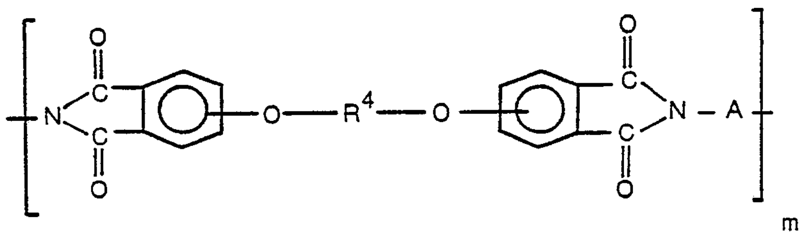 (I)

dans laquelle il y a de 40 à 99 moles% d'unités de structure intercondensées définies par la formule générale:

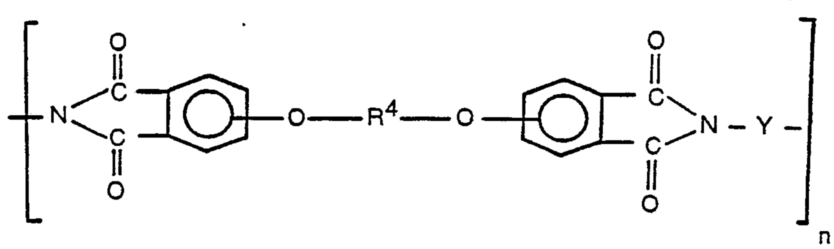 (II),

ou au moins partiellement par la formule générale:

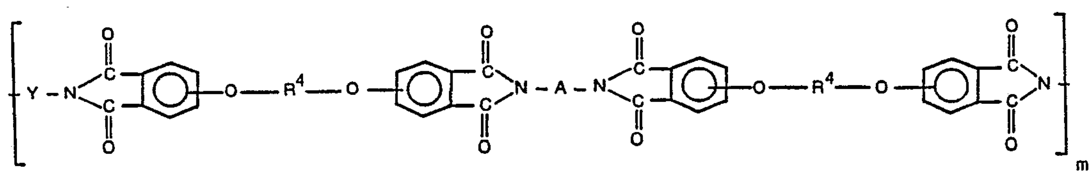 (III),

où, dans les formules générales (I) et (III), A est une silicone ayant pour formule générale:

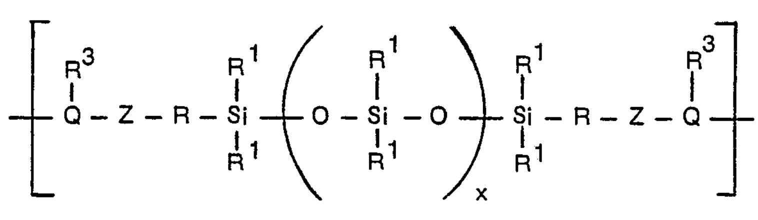 (IV),

où

Q est un noyau aromatique;

R est un groupe divalent ou un groupe divalent fonctionnel;

$R^1$ est choisi parmi des radicaux hydrocarbures monovalents et des radicaux hydrocarbures fonctionnels, les radicaux $R^1$ dans la formule (IV) étant les mêmes ou différents les uns des autres;

$R^3$ est de l'hydrogène, un radical hydrocarbure ou un groupe fonctionnel ou atome;

x est 0 ou un nombre entier de 1 ou plus;

Z est —O—, —S—, 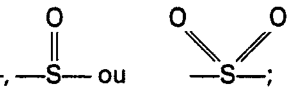;

m et n sont des nombres entiers identiques ou différents et ils sont supérieurs à 1;

Y est un radical organique divalent exempt de silicium qui est le résidu d'un diamine organique ou d'un éther couronne macrocyclique et $R^4$ est une liaison directe ou un radical organique divalent, les liaisons divalentes du groupement —O—$R^4$—O— étant liées symétriquement aux groupes extrêmes de phtalimide; et

au moins un solvant organique (2) choisi parmi des monoalkyl éthers d'éthylène glycol, monoalkyl éthers de polyéthylène glycol condensé, dialkyl éthers d'éthylène glycol, dialkyl éthers de polyéthylène glycol condensé et éthers cycliques ne contenant pas moins d'un noyau à cinq éléments.

2. Composition de revêtement selon la revendication 1 où $R^4$ est un radical organique divalent de formule générale

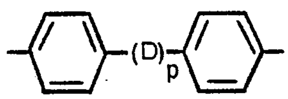

(V)

où D est choisi parmi

—$C_y H_{2y}$—, 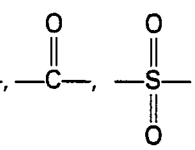 et —S—,

p étant 0 ou 1 et y est 0 ou un nombre entier de 1 à 5.

3. Composition de revêtement selon la revendication 1 ou la revendication 2, où le groupement —O—$R^4$—O est lié symétriquement aux groupes extrêmes de phtalimide aux positions 3,3'- ou 4,4'-.

4. Composition de revêtement selon l'une quelconque des revendications précédentes où m et n sont de 10 à 10.000.

5. Composition de revêtement selon l'une quelconque des revendications précédentes, où le matériau de copolymère durcissable (1) a été dérivé par une réaction de condensation entre des quantités molaires correspondantes d'une diamine organique (x) et d'une silicone (y) contenant un groupement bis-amino aryl éther ou un groupement bis-amino aryl thioéther et un dianhydride organique (z), la réaction étant effectuée en faisant réagir (x) + (z) puis avec (y) ou en faisant réagir (y) + (z) puis avec (x), ou bien le matériau du copolymère durcissable a été dérivé par une réaction de condensation entre des quantités molaires correspondantes d'une diamine organique ($x^1$) qui contient, dans sa structure, le groupement requis de silicone et un dianhydride organique (z).

6. Composition de revêtement selon l'une quelconque des revendications précédentes, où $R^4$ a une formule choisie dans ce qui suit:

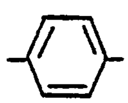 , 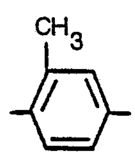 , 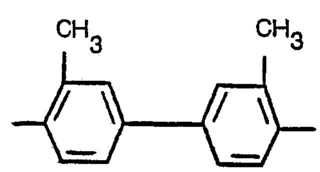 ,

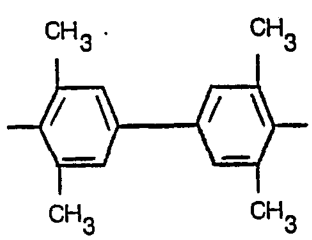 , 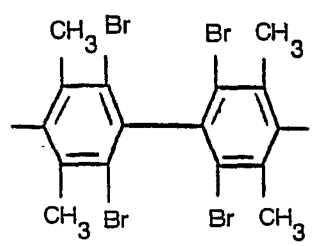 , 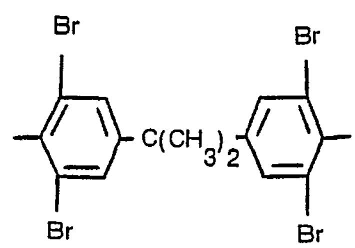 .

7. Composition de revêtement selon la revendication 6 où la diamine organique (x) est du 4,4'-diaminodiphénylméthane, de la m-phénylène diamine ou de la p-phénylène diamine.

8. Composition de revêtement selon la revendication 6 ou la revendication 7, où la silicone (y) est du bis-(p-aminophénoxybutyl)tétraméthyldisiloxane, du bis-(m-aminophénoxybutyl)tétraméthyldisiloxane, du bis-(m-aminophénoxypropyl)tétraméthyldisiloxane, du bis-(m-aminophénylthiobutyl)-tétraméthyldisiloxane ou du bis-(p-aminophénoxythiobutyl)tétraméthyldisiloxane.

9. Composition de revêtement selon la revendication 5 ou toute revendication en dépendant, où jusqu'à 50 moles% du dianhydride organique total requis pour le système réactionnel avec les composés diamino fonctionnels comprend au moins un dianhydride organique tétracarboxylique ne contenant pas de liaison éther et ayant la formule générale:

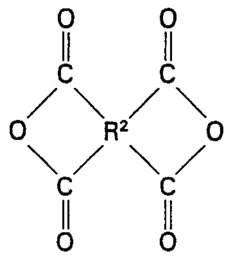

(VI)

où $R^2$ est un radical organique tétravalent, le produit de la réaction de condensation contient jusqu'à 50 moles% d'unités récurrentes de structure de formule générale

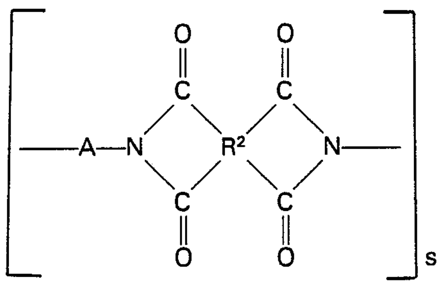

(VII)

où $R^2$ est tel que défini ci-dessus, A est tel que défini à la revendication 1 et s est un nombre entier supérieur à 1, avec de 1 à 99 moles% de jusqu'à 50 moles% des unités récurrentes de structure qui prédèdent, ayant des unités de structure intercondensées de formule générale

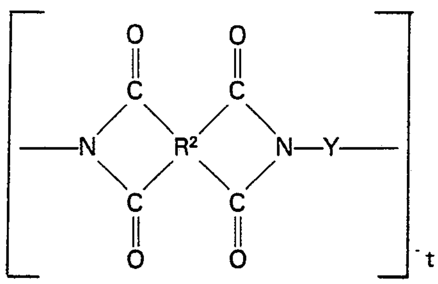

(VIII)

où $R^2$ est tel que défini ci-dessus, Y est tel que défini à la revendication 1 et t est un nombre entier supérieur à 1.

10. Composition de revêtement selon la revendication 9, où s et t sont des nombres entiers identiques ou différents de 10 à 10.000.

11. Composition de revêtement selon l'une quelconque des revendications précédentes, où la teneur totale en solides dans le matériau de copolymère durcissable (1) dans la composition de revêtement est d'au moins 25%.

12. Composition de revêtement selon l'une quelconque des revendications précédentes, où le ou les solvants organiques (2) comprend ou comprennent du diéthylène glycol diméthyl éther.

FIG. 1

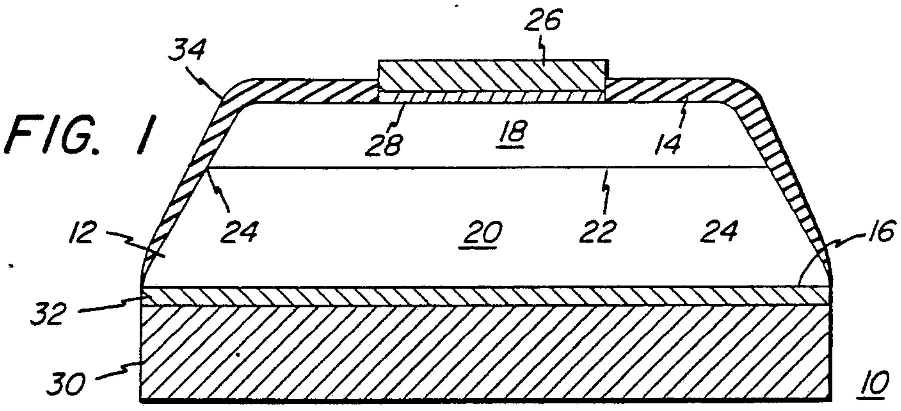


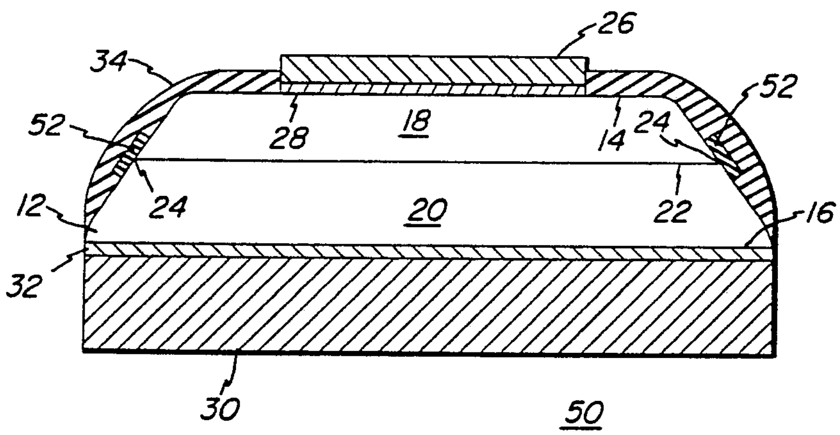


FIG. 2

FIG. 3

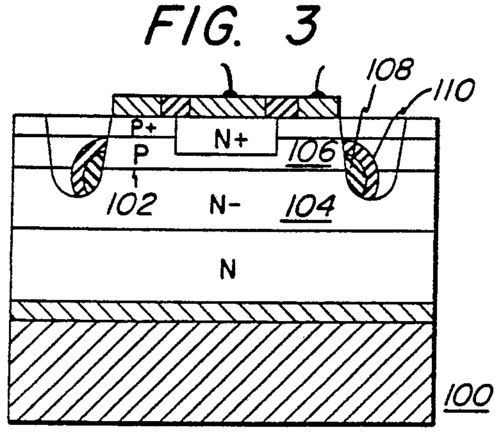


FIG. 4

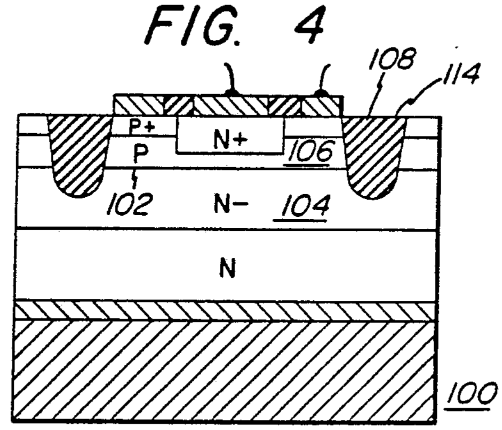


FIG. 5

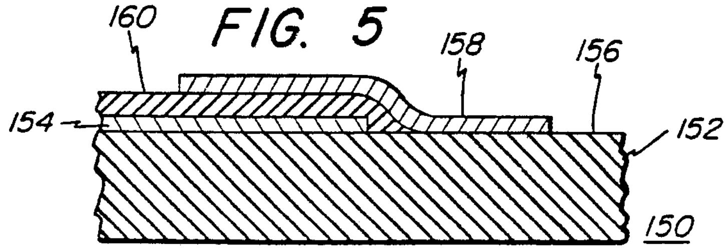


FIG. 6